# FASCICULE DE BREVET EUROPEEN

(11) **EP 3 326 195 B1**
(45) Date de publication et mention de la délivrance du brevet: **14.09.2022**
(21) Numéro de dépôt: 16741587.6
(22) Date de dépôt: 13.07.2016
(51) Int. Cl.: H01L 21/02

(54) **PROCÉDÉ DE FABRICATION D'UN SUBSTRAT**
VERFAHREN ZUR HERSTELLUNG EINES SUBSTRATS
METHOD FOR MANUFACTURING A SUBSTRATE

(30) Priorité: 17.07.2015 FR 1501519
(43) Date de publication de la demande: 30.05.2018
(73) Titulaire: Soitec, 38190 Bernin (FR)
(72) Inventeur: GUENARD, Pascal, 38190 Froges (FR); BROEKAART, Marcel, 38570 Theys (FR); BARGE, Thierry, 38160 Chevrieres (FR)
(74) Mandataire: Grünecker Patent- und Rechtsanwälte PartG mbB
(86) Numéro de dépôt international: PCT/EP2016/066609
(87) Numéro de publication internationale: WO 2017/012940

(56) Documents cités:
- FR-A1- 2 942 911
- JP-A- H0 992 895
- US-A1- 2002 180 316
- US-A1- 2005 026 394
- US-A1- 2009 267 083

## Description

### DOMAINE DE L'INVENTION

L'invention concerne un procédé de fabrication d'un substrat comprenant un substrat support 1 présentant un premier coefficient de dilatation thermique (« CTE » ou « coefficient of thermal expansion » selon la terminologie anglosaxonne) et une couche utile présentant un second coefficient de dilatation thermique différent du premier coefficient de dilatation thermique.

### ARRIERE PLAN TECHNOLOGIQUE DE L'INVENTION

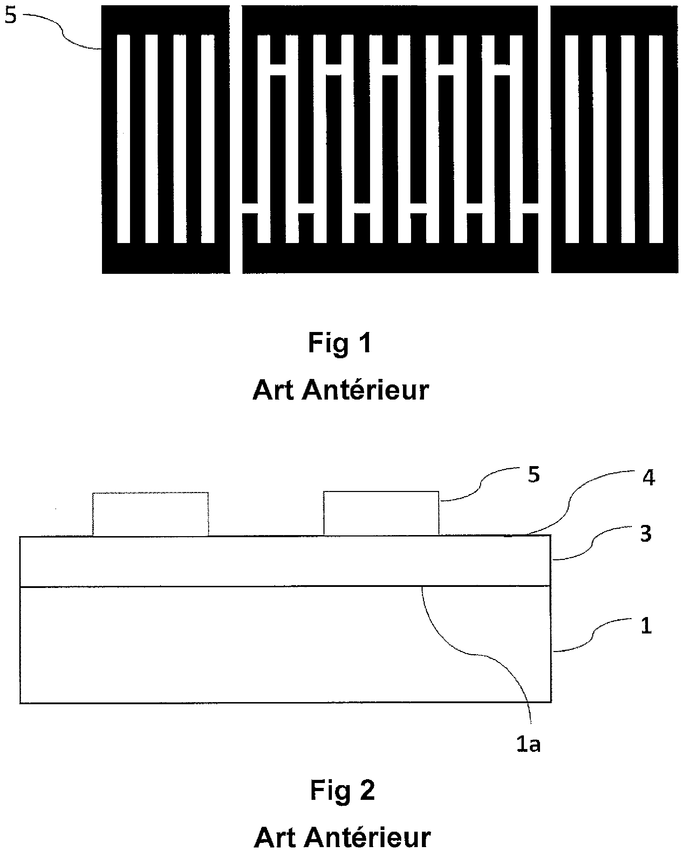

La fabrication des filtres à ondes acoustiques de surfaces (« F SAW » ou « Surface Acoustic Wave Filters » selon la terminologie anglosaxonne) peut comprendre des électrodes métalliques à peignes inter digitées 5 formées sur une face d'un matériau piezoélectrique, par exemple du tantalate de lithium LiTaO₃ tel qu'illustré à la figure 1.

Les caractéristiques géométriques des électrodes à peignes inter digités, telles que la taille de peignes, ou encore leur espacement déterminent la fréquence de résonnance et le facteur de qualité des filtres « F SAW ».

A cet égard, l'homme du métier pourra ce référer à l'article « recent development of temperature cmensated SAW devices, Ken-ya Hashimoto et al., Ultrasonics Symposium (IUS), 2011 IEEE Internationa, p. 79 - 86 ».

En condition normale d'utilisation, les filtres peuvent être soumis à des températures comprises dans la gamme -40°C à 85°C.

Cependant, les matériaux piézoélectriques tels que le tantalate de lithium présentent un coefficient de dilatation thermique de l'ordre de 14 selon au moins une de ces directions cristallographique.

Par conséquent, les variations de température induisent une variabilité des caractéristiques géométriques des filtres « F SAW ».

Pour pallier à ce problème, il est possible de positionner un substrat raidisseur sur une face du matériau piézoélectrique.

La figure 2 présente une structure comprenant un substrat de silicium 1, une couche de LiTaO₃ 3 formée sur le substrat de silicium, et des électrodes métalliques à peignes inter digités 5 sur la surface libre 4 de la couche de LiTaO₃.

Le faible coefficient de dilatation thermique du silicium, ce dernier étant égale à 2.6*10⁻⁶/°C, permet de limiter la dilatation de la couche de LiTaO₃ et par conséquent de limiter les variations de la fréquence de résonnance et du facteur de qualité du filtre « F SAW ». Cet effet sera appelé par la suite compensation thermique.

Le procédé de fabrication d'un substrat comportant une couche de LiTaO3 sur un substrat de silicium implique les étapes de fabrication suivantes :
a. La fourniture d'un substrat support 1, par exemple en silicium ;
b. Le transfert d'une couche de LiTaO₃ 3 sur une des faces du substrat support 1, dite face avant 1a;

Le transfert de la couche de LiTaO₃ est généralement exécuté par assemblage d'un substrat de LiTaO₃ avec un substrat de silicium, et suivi d'une étape d'amincissement, mécanique par exemple, du substrat LiTaO₃.

Ce procédé n'est cependant pas satisfaisant car il requiert un renforcement de l'interface d'assemblage de l'empilement LiTaO₃ sur silicium par traitement thermique.

En effet, les différences de coefficient d'expansion thermique du LiTaO₃ et du silicium provoquent une dégradation de l'interface d'assemblage, à savoir un décollement et / ou l'apparition de fissures dans la couche de LiTaO₃.

Le document US 2009/0267083 A1 propose alors de pallier aux inconvénients précités en réalisant un réseau de tranchées sur la face arrière du substrat support 1. La réalisation desdites tranchées permet de limiter les contraintes à l'interface d'assemblage et donc d'assurer l'intégrité de la couche utile.

Cette solution n'est pas satisfaisante car elle ne permet pas d'accommoder de grandes différences de coefficient de dilatation thermique.

FR 2 942 911 A1 et JP H09 92895 A divulgue aussi l'utilisation de tranchées dans les substrats.

Un objet de la présente invention est donc de proposer un procédé de fabrication d'un substrat adapté pour resister à un traitement thermique tout en conservant l'effet de compensation thermique.

### BREVE DESCRIPTION DE L'INVENTION

L'invention vise à résoudre le problème technique et concerne un procédé de fabrication d'un substrat selon la revendication 1.

Ainsi, la présence de la première pluralité de tranchées permet de rompre le champ de contraintes s'exerçant à l'interface formée entre la couche intermédiaire et le substrat support.

Par ailleurs, la présence de la couche intermédiaire permet de limiter l'effet de la différence entre le premier et le second coefficient de dilatation thermique, tout en préservant un effet de compensation thermique.

En outre, la présence de la couche intermédiaire permet d'avoir un espacement entre les tranchées de chacune des pluralités de tranchées supérieure à la dimension d'un « F SAW » destiné à être formé sur le substrat ainsi obtenu.

Selon un mode de réalisation, l'etape b. de transfert de la couche utile comprend l'amincissement du substrat donneur pour former la couche utile.

Selon un mode de réalisation, l'amincissement du substrat donneur est exécuté par amincissement mécanique.

Selon un mode de réalisation, la couche intermédiaire est formée, avant l'étape b. de transfert de la couche utile, sur le substrat support ou sur le substrat donneur.

Selon un mode de réalisation, la couche intermédiaire comprend un matériau vitreux.

Selon un mode de réalisation, la couche intermédiaire comprend au moins un des matériaux compris dans la liste : TEOS, BPSG, PSG, USG

Selon un mode de réalisation, les tranchées de la première pluralité de tranchées sont régulièrement disposées tous les 3 à 10 millimètres.

Selon un mode de réalisation non couvert par les revendications, les tranchées de la seconde pluralité de tranchées sont régulièrement disposées tous les 3 à 10 millimètres.

Selon un mode de réalisation, les tranchées de la première pluralité de tranchées ont une profondeur comprise entre 1 et 100 µm.

Selon un mode de réalisation, les tranchées de la première pluralité de tranchées présentent une largeur comprise entre 1 et 100 µm.

Selon un mode de réalisation, la couche utile comprend au moins un des matériaux compris dans la liste : LiTaO3, LiNbO3.

Selon un mode de réalisation, la différence entre le premier coefficient de dilatation thermique et le second coefficient de dilatation thermique est supérieur à 5* 10⁻⁶ /°C, de préférence supérieur à 10* 10⁻⁶ /°C.

Selon un mode de réalisation, le substrat support comprend au moins un des matériaux compris dans la liste : Silicium, Germanium, Carbure de silicium, alumine, saphir, Nitrure d'aluminium.

L'invention concerne également un substrat selon la revendication 13.

### DESCRIPTION DES DESSINS

L'invention sera mieux comprise à la lumière de la description qui suit des modes de réalisation, particuliers et non limitatifs, de l'invention en référence aux figures ci-jointes parmi lesquelles :
- Figure 1 : représentation de peignes interdigités formant un filtre à ondes acoustiques de surface ;
- Figure 2 : représentation d'un substrat utilisé pour la fabrication de filtre à ondes acoustiques de surface selon les techniques de l'art antérieur ;

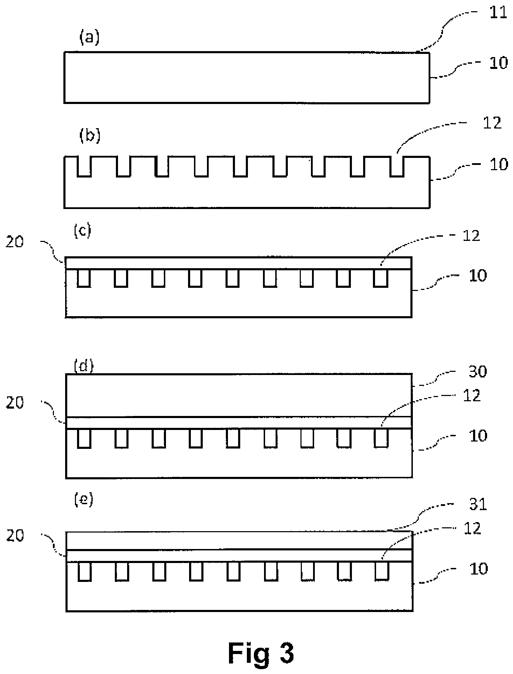

- Figure 3 : représentation schématique d'un mode de réalisation du procédé de fabrication selon l'invention.

### DESCRIPTION DETAILLEE DE L'INVENTION

Pour les différents modes de mise en œuvre, les mêmes références seront utilisées pour des éléments identiques ou assurant la même fonction, par souci de simplification de la description.

Le procédé selon l'invention comprend une étape a., de fourniture d'un substrat support 10 présentant un premier coefficient de dilation thermique.

Le substrat support 10 peut comprendre au moins un des matériaux choisi parmi la liste : Silicium, Germanium, Carbure de silicium, alumine, saphir, Nitrure d'aluminium.

Le substrat support 10 présente un coefficient de dilatation thermique compris entre 2*10⁻⁶ et 9*10⁻⁶/°C.

Par exemple, un substrat support 10 en silicium présente un coefficient de dilatation thermique de 2.6*10⁻⁶/°C.

Le substrat support 10 comprend également sur une de ses face, dite face avant 11, une première pluralité de tranchées 12. Les tranchées de la première pluralité de tranchées 12 sont parallèles entre elles selon une première direction.

Le substrat support 10 peut comprendre également, sur sa face avant 11, une seconde pluralité de tranchées 13 (non représentée). Les tranchées de la seconde pluralité de tranchées 13 sont parallèles entre elles selon une seconde direction. La seconde direction n'est pas parallèle à la première direction.

Les tranchées de la première pluralité de tranchées 12 peuvent être régulièrement disposées tous les 3 à 10 millimètres.

Les tranchées de la seconde pluralité de tranchées 13 peuvent être régulièrement disposées tous les 3 à 10 millimètres.

Les tranchées de la première pluralité de tranchées 12 peuvent avoir une profondeur comprise entre 1 et 100 µm.

Les tranchées de la seconde pluralité de tranchées 13 peuvent avoir une profondeur comprise entre 1 et 100 µm.

Les tranchées de la première pluralité de tranchées 12 et de la seconde pluralité de tranchées 13 peuvent présenter une largeur comprise entre 1 et 100 µm.

Les tranchées de la première pluralité de tranchées 12 et de la seconde pluralité de tranchées 13 peuvent être formées par une roue de sciage généralement utilisée dans l'industrie de la microélectronique. Les techniques de sciage avec une telle roue de sciage sont en soit bien connues de l'home du métier.

La largeur des tranchées de la première et de la seconde pluralité de tranchées 13 est définie par l'épaisseur de la roue de sciage.

Par ailleurs, la profondeur des tranchées est également définie par la profondeur de sciage.

Les tranchées des première et seconde pluralités de tranchées peuvent également être réalisées par formation d'un masque de gravure sur la face avant 11 du substrat support 10. Ledit masque de gravure dessine sur la face avant 11 du substrat support 10 la forme des tranchées de la première et de la première pluralité de tranchées 13.

La gravure formant les tranchées est alors exécutée en utilisant une gravure appropriée.

Par exemple, le substrat support 10 en silicium, le masque de gravure est en dioxyde de silicium, et la gravure est exécutée à l'aide d'une solution de KOH.

Après la formation des tranchées de la première et de la première pluralité de tranchées 13, une couche intermédiaire 20 est formée sur la face avant 11 du substrat support 10.

La couche intermédiaire 20 peut recouvrir de manière conforme la face avant 11 du substrat support 10 en épousant la forme des tranchées.

La couche intermédiaire 20 peut présenter une épaisseur comprise en 0.5 et 50 µm.

De manière avantageuse, la couche intermédiaire 20 peut se déformer plastiquement lorsqu'elle est soumise à un traitement thermique présentant une montée en température.

De manière avantageuse, la couche intermédiaire 20 peut comprendre un matériau vitreux.

Par exemple, la couche intermédiaire 20 peut comprendre au moins un des matériaux compris dans la liste : verre de borophosphosilicate (BPSG), oxide orthosilicate de tétraéthyle (oxyde TEOS), verre de phosphosilicate (PSG), Verre de silicate non dopé (USG).

Le procédé selon l'invention comprend également une étape b., qui comprend la formation d'une couche utile 31 sur la couche intermédiaire 20.

La couche utile 31 peut être formée par un procédé de transfert de couche à partir d'un substrat donneur 30.

L'étape de transfert peut comprendre l'assemblage d'un substrat donneur 30 avec la couche intermédiaire 20.

L'étape d'assemblage peut être une étape de collage par adhésion moléculaire.

Une étape de traitement thermique peut être exécutée de manière à renforcer l'interface de collage.

Par exemple, un traitement thermique peut être exécuté à une température comprise entre 80°C et 150°C, de préférence entre 100°C et 120°C, pendant une durée comprise entre 30 minutes et 4 heures, sous atmosphère non oxydante, par exemple sous azote et/ou argon et/ou hélium.

Afin de renforcer l'interface de collage, la surface du substrat donneur 30 destinée à être mise en contact avec la couche intermédiaire 20 peut être activée par plasma.

Par exemple, l'activation peut être exécutée avec un plasma de dioxygène (02) ou de diazote (N2), pendant 30 secondes, à une puissance de 500 Watt, et une pression de 50 mTorr.

L'étape d'assemblage est alors suivie d'un amincissement du substrat donneur 30. Ainsi le substrat donneur 30 aminci forme la couche utile 31.

L'amincissement du substrat donneur 30 peut être exécuté par des techniques bien connue de l'homme du métier, telles que l'amincissement mécanique (« grinding » selon la terminologie Anglo-Saxonne), et/ou par polissage mécano-chimique.

La couche utile 31 peut alors, à la suite de l'étape d'amincissement du substrat donneur 30, présenter une épaisseur comprise entre 5 et 50 µm.

Selon une variante du procédé de fabrication selon l'invention, la couche intermédiaire 20 peut être formée sur le substrat donneur 30. Dans ces conditions, l'étape d'assemblage comprend la mise en contact de la couche intermédiaire 20 avec la face avant 11 du substrat support 10.

La couche utile 31 présente un second coefficient de dilatation thermique différent du premier coefficient de dilation thermique.

La couche utile 31 peut comprendre un matériau de type pérovskite.

La couche utile 31 peut comprendre un matériau diélectrique, de manière préférentielle le matériau est un matériau ferroélectrique.

La couche utile 31 peut comprendre au moins un des matériaux compris dans la liste : LiTaO3, LiNbO3.

Selon l'invention, la couche intermédiaire 20 présente un coefficient de dilatation thermique compris entre le premier coefficient de dilatation thermique et le second coefficient de dilatation thermique.

L'écart entre le premier coefficient de dilatation thermique et le second coefficient de dilatation thermique est supérieur à 5*10⁻⁶/°C, de préférence supérieur à 10*10⁻⁶/°C.

Pour de tels écarts de coefficient de dilatation thermique, le procédé selon l'invention permet d'assurer l'intégrité de l'empilement comprenant la substrat support 10, la couche intermédiaire 20 et la couche utile 31 lors d'un recuit thermique.

De cette manière, la présence de la couche intermédiaire 20 permet de limiter l'effet de la différence entre le premier et le second coefficient de dilatation thermique, tout en préservant un effet de compensation thermique.

Par ailleurs, la présence d'au moins la première pluralité de tranchées 12 sur la face avant 11 du substrat support 10 permet de rompre la continuité des contraintes présentes à l'interface formée par la couche intermédiaire 20 et ladite face avant 11.

Ainsi, pris en combinaison, l'effet de la couche intermédiaire 20 et la présence de la au moins première pluralité de tranchées 12 permet de limiter les contraintes s'exerçant sur les interfaces formées d'une part, par la couche utile 31 et la couche intermédiaire 20, et d'autre part, par la couche intermédiaire 20 et le substrat support 10.

### Premier mode de réalisation

Selon un premier mode de réalisation, l'invention comprend la fourniture d'un substrat support 10 en Silicium.

La première pluralité de tranchées 12 est réalisée avec une roue de sciage. Les tranchées de première pluralité de tranchées 12 sont espacées de 3 mm les unes des autres, présentent une profondeur de 100 µm, et une largeur de 100 µm.

La couche intermédiaire 20, formée directement sur la face avant 11 du substrat support 10, est en verre de borophosphosilicate, et son épaisseur est comprise entre 0.5 et 50 µm, par exemple 2µm.

La couche intermédiaire 20 est conforme à la topographie de la face avant 11 du substrat support 10.

Toujours selon le premier mode de réalisation, un substrat donneur 30 de LiTaO₃ est fourni.

La surface du substrat donneur 30 destinée à être mise en contact avec la couche intermédiaire 20 est activée par plasma comprenant du dioxygène.

La surface du substrat donneur 30 activée est alors assemblée avec la couche intermédiaire 20 par adhésion moléculaire.

L'interface d'assemblage formée par le substrat donneur 30 et la couche intermédiaire 20 est renforcée par un recuit thermique exécuté à 100°C pendant 3 heures sous atmosphère d'argon.

Le substrat donneur 30 est ensuite aminci mécaniquement à une épaisseur de 20 µm, pour former la couche utile 31.

### Second mode de réalisation

Le second mode de réalisation diffère du premier mode de réalisation en ce que la couche intermédiaire 20 est formée sur le substrat donneur 30 plutôt que sur la face avant 11 du substrat support 10, et en ce que l'activation plasma est réalisée sur la face avant 11 du substrat support 10.

## Revendications

1. Procédé de fabrication d'un substrat comprenant une couche utile (31) disposée sur un substrat receveur, le procédé comprenant les étapes suivantes :
a. Fournir un substrat support (10) présentant un premier coefficient de dilatation thermique, comprenant sur une de ses faces, dite face avant (11), une première pluralité de tranchées (12) parallèles entre elles selon une première direction;
b. Transférer une couche utile (31), à partir d'un substrat donneur (30), sur le substrat support (10), la couche utile (31) présentant un second coefficient de dilatation thermique différent du premier coefficient de dilatation thermique ;
le procédé de fabrication **étant caractérisé en ce que** le transfert de la couche utile (31) comprend assembler le substrat donneur (30) avec le substrat support (10) avec une couche intermédiaire (20), ladite couche intermédiaire (20) étant intercalée entre la face avant (11) du substrat support (10) et la couche utile (31) et présentant un coefficient de dilatation compris entre le premier et le second coefficient de dilatation thermique.

2. Procédé de fabrication selon la revendication 1, dans lequel l'étape b. de transfert de la couche utile (31) comprend l'amincissement du substrat donneur (30) pour former la couche utile (31).

3. Procédé de fabrication selon la revendication 2, dans lequel l'amincissement du substrat donneur (30) est exécuté par amincissement mécanique.

4. Procédé de fabrication selon l'une des revendications 1 à 3, dans lequel la couche intermédiaire (20) est formée, avant l'étape b. de transfert de la couche utile (31), sur le substrat support (10) ou sur le substrat donneur (30).

5. Procédé de fabrication selon l'une des revendications 1 à 4, dans lequel la couche intermédiaire (20) comprend un matériau vitreux.

6. Procédé de fabrication selon la revendication 5 dans lequel la couche intermédiaire (20) comprend au moins un des matériaux compris dans la liste : TEOS, BPSG, PSG, USG.

7. Procédé de fabrication selon l'une des revendications 1 à 6, dans lequel les tranchées de la première pluralité de tranchées (12) sont régulièrement disposées tous les 3 à 10 millimètres.

8. Procédé de fabrication selon l'une des revendications 1 à 7, dans lequel les tranchées de la première pluralité de tranchées ont une profondeur comprise entre 1 et 100 µm.

9. Procédé de fabrication selon l'une des revendications 1 à 8, dans lequel les tranchées de la première pluralité de tranchées (13) présentent une largeur comprise entre 1 et 100 µm.

10. Procédé de fabrication selon l'une des revendications 1 à 9, dans lequel la couche utile (31) comprend au moins un des matériaux compris dans la liste : LiTa03, LiNb03.

11. Procédé de fabrication selon l'une des revendications 1 à 10, dans lequel la différence entre le premier coefficient de dilatation thermique et le second coefficient de dilatation thermique est supérieur à 5*10⁻⁶/C°, de préférence supérieur à 10*10⁻⁶/C°.

12. Procédé de fabrication selon l'une des revendications 1 à 11, dans lequel le substrat support (10) comprend au moins un des matériaux compris dans la liste : Silicium, Germanium, Carbure de silicium, alumine, saphir, Nitrure d'aluminium.

13. Substrat comprenant :
a. un substrat support (10) présentant un premier coefficient de dilatation thermique, et comprenant sur une de ces faces, dite face avant (11), une première pluralité de tranchées (12) parallèles entre elles selon une première direction;
b. une couche utile (31) présentant un second coefficient de dilatation thermique différent du premier coefficient de dilatation thermique et disposée sur le substrat support (10) ;
le substrat **étant caractérisé en ce que** une couche de intermédiaire est intercalée entre la face avant (11) du substrat support (10) et la couche utile (31), la couche intermédiaire (20) présentant un coefficient de dilatation compris entre le premier et le second coefficient de dilatation thermique.

## Patentansprüche

1. Verfahren zur Herstellung eines Substrats mit einer Nutzschicht (31), die auf einem Empfängersubstrat angeordnet ist, wobei das Verfahren die folgenden Schritte umfasst:
a. Bereitstellen eines Trägersubstrats (10), das einen ersten Wärmeausdehnungskoeffizienten aufweist und das auf einer seiner Seiten, der so genannten Vorderseite (11), eine erste Vielzahl von Gräben (12) aufweist, die in einer ersten Richtung zueinander parallel sind;
b. Übertragen einer Nutzschicht (31) von einem Donorsubstrat (30) auf das Trägersubstrat (10), wobei die Nutzschicht (31) einen zweiten Wärmeausdehnungskoeffizienten aufweist, der sich von dem ersten Wärmeausdehnungskoeffizienten unterscheidet;
wobei das Herstellungsverfahren, **dadurch gekennzeichnet ist, dass** das Übertragen der Nutzschicht (31) das Zusammenfügen des Donorsubstrats (30) mit dem Trägersubstrat (10) mit einer Zwischenschicht (20) umfasst, wobei besagte Zwischenschicht (20) zwischen der Vorderseite (11) des Trägersubstrats (10) und der Nutzschicht (31) angeordnet ist und einen Wärmeausdehnungskoeffizienten aufweist, der zwischen dem ersten und dem zweiten Wärmeausdehnungskoeffizienten liegt.

2. Herstellungsverfahren nach Anspruch 1, worin der Schritt b. des Übertragens der Nutzschicht (31) das Verdünnen des Donorsubstrats (30) umfasst, um die Nutzschicht (31) zu bilden.

3. Herstellungsverfahren nach Anspruch 2, worin das Ausdünnen des Donorsubstrats (30) durch mechanisches Ausdünnen durchgeführt wird.

4. Herstellungsverfahren nach einem der Ansprüche 1 bis 3, worin die Zwischenschicht (20) vor dem Schritt b. des Übertragens der Nutzschicht (31) auf das Trägersubstrat (10) oder auf das Donorsubstrat (30) gebildet wird.

5. Herstellungsverfahren nach einem der Ansprüche 1 bis 4, worin die Zwischenschicht (20) ein glasartiges Material umfasst.

6. Herstellungsverfahren nach Anspruch 5, worin die Zwischenschicht (20) zumindest eines der folgenden Materialien umfasst: TEOS, BPSG, PSG, USG.

7. Herstellungsverfahren nach einem der Ansprüche 1 bis 6, worin die Gräben der ersten Vielzahl von Gräben (12) regelmäßig alle 3 bis 10 Millimeter angeordnet sind.

8. Herstellungsverfahren nach einem der Ansprüche 1 bis 7, worin die Gräben der ersten Vielzahl von Gräben eine Tiefe zwischen 1 und 100 µm aufweisen.

9. Herstellungsverfahren nach einem der Ansprüche 1 bis 8, worin die Gräben der ersten Vielzahl von Gräben (13) eine Breite zwischen 1 und 100 µm aufweisen.

10. Herstellungsverfahren nach einem der Ansprüche 1 bis 9, worin die Nutzschicht (31) zumindest eines der folgenden Materialien umfasst: LiTa03, LiNb03.

11. Herstellungsverfahren nach einem der Ansprüche 1 bis 10, worin die Differenz zwischen dem ersten Wärmeausdehnungskoeffizienten und dem zweiten Wärmeausdehnungskoeffizienten größer als 5*10⁻⁶/°C, bevorzugt größer als 10*10⁻⁶/°C, ist.

12. Herstellungsverfahren nach einem der Ansprüche 1 bis 11, worin das Trägersubstrat (10) zumindest eines der Materialien aus der folgenden Liste umfasst: Silizium, Germanium, Siliciumcarbid, Aluminiumoxid, Saphir, Aluminiumnitrid.

13. Substrat, das Folgendes umfasst:
a. ein Trägersubstrat (10), das einen ersten Wärmeausdehnungskoeffizienten aufweist und auf einer dieser Seiten, der so genannten Vorderseite (11), eine erste Vielzahl von Gräben (12) aufweist, die in einer ersten Richtung zueinander parallel sind;
b. eine Nutzschicht (31), die einen zweiten Wärmeausdehnungskoeffizienten aufweist, der sich von dem ersten Wärmeausdehnungskoeffizienten unterscheidet, und die auf dem Trägersubstrat (10) angeordnet ist;
wobei das Substrat **dadurch gekennzeichnet ist, dass** eine Zwischenschicht zwischen der Vorderseite (11) des Trägersubstrats (10) und der Nutzschicht (31) angeordnet ist, wobei die Zwischenschicht (20) einen Wärmeausdehnungskoeffizienten zwischen dem ersten und dem zweiten Wärmeausdehnungskoeffizienten aufweist.

## Claims

1. Method for manufacturing a substrate comprising a useful layer (31) disposed on a receiving substrate, the method comprising the following steps:
a. providing a support substrate (10) having a first coefficient of thermal expansion, comprising on one of its faces, called the front face (11), a first plurality of trenches (12) parallel to each other in a first direction;
b. transferring a useful layer (31) from a donor substrate (30) onto the support substrate (10), the useful layer (31) having a second coefficient of thermal expansion different from the first coefficient of thermal expansion;
the manufacturing method **being characterized in that** the transfer of the useful layer (31) comprises assembling the donor substrate (30) with the support substrate (10) with an intermediate layer (20), said intermediate layer (20) being interposed between the front face (11) of the support substrate (10) and the useful layer (31) and having a coefficient expansion comprised between the first and second coefficient of thermal expansion.

2. The manufacturing method according to claim 1, wherein the step b. of transferring the useful layer (31) comprises thinning the donor substrate (30) to form the useful layer (31).

3. The manufacturing method according to claim 2, wherein the thinning of the donor substrate (30) is performed by mechanical thinning.

4. The manufacturing method according to anyone of claims 1 to 3, wherein the intermediate layer (20) is formed, before the step b. of transferring the useful layer (31), on the support substrate (10) or on the donor substrate (30).

5. The manufacturing method according to anyone of claims 1 to 4, wherein the intermediate layer (20) comprises a vitreous material.

6. The manufacturing method according to claim 5, wherein the intermediate layer (20) comprises at least one of the materials included in the list: TEOS, BPSG, PSG, USG.

7. The manufacturing method according to anyone of claims 1 to 6, wherein the trenches of the first plurality of trenches (12) are regularly disposed every 3 to 10 millimeters.

8. The manufacturing method according to anyone of claims 1 to 7, wherein the trenches of the first plurality of trenches have a depth in the range of 1 to 100 µm.

9. The manufacturing method according to anyone of claims 1 to 8, wherein the trenches of the first plurality of trenches (13) have a width in the range of 1 to 100 µm.

10. The manufacturing method according to anyone of claims 1 to 9, wherein the useful layer (31) comprises at least one of the materials included in the list: LiTa03, LiNb03

11. The manufacturing method according to anyone of the claims 1 to 10, wherein the difference between the first coefficient of thermal expansion and the second coefficient of thermal expansion is greater than 5*10⁻⁶/C°, preferably greater than 10*10⁻⁶/C°.

12. The manufacturing method as claimed in anyone of claims 1 to 11, wherein the support substrate (10) comprises at least one of the materials included in the list: silicon, germanium, silicon carbide, alumina, sapphire, aluminum nitride.

13. A substrate comprising:
a. providing a support substrate (10) having a first coefficient of thermal expansion, comprising on one of its faces, called the front face (11), a first plurality of trenches (12) parallel each other in a first direction;
b. a useful layer (31) having a second thermal expansion coefficient different from the first thermal expansion coefficient and disposed on the support substrate (10);
the substrate **being characterized in that** an intermediate layer is interposed between the front face (11) of the support substrate (10) and the useful layer (31), the intermediate layer (20) having a coefficient of expansion comprised between the first and second coefficient of thermal expansion.
